**Europäisches Patentamt**

**European Patent Office**

**Office européen des brevets**

(19)

(11) Veröffentlichungsnummer : **0 465 713 B1**

(12) ## EUROPÄISCHE PATENTSCHRIFT

(45) Veröffentlichungstag der Patentschrift :
**20.09.95 Patentblatt 95/38**

(51) Int. Cl.$^6$ : **H03M 1/86**, H03M 3/02

(21) Anmeldenummer : **90113417.1**

(22) Anmeldetag : **13.07.90**

(54) CMOS-Schaltung für mittelwertbildende Digital-Analogumsetzer.

(43) Veröffentlichungstag der Anmeldung :
**15.01.92 Patentblatt 92/03**

(45) Bekanntmachung des Hinweises auf die
Patenterteilung :
**20.09.95 Patentblatt 95/38**

(84) Benannte Vertragsstaaten :
**DE FR GB IT NL**

(56) Entgegenhaltungen :
**EP-A- 0 335 988**

(73) Patentinhaber : **Deutsche ITT Industries GmbH**
**Hans-Bunte-Strasse 19**
**D-79108 Freiburg (DE)**

(72) Erfinder : **Theus, Ulrich, Dr. Ing.**
**Schönbergstrasse 5b**
**D-7803 Gundelfingen (DE)**

EP 0 465 713 B1

## Beschreibung

Die Erfindung betrifft eine CMOS-Schaltung für mittelwertbildende Digital-Analogumsetzer, die als Teilschaltung bei der Pulsdichte-Digital-Analogumsetzung oder Pulsdichte-Analog-Digitalumsetzung verwendet wird. Anstelle des Begriffes "Pulsdichtemodulation" wird häufig auch der Begriff "Sigma-Delta-Modulation" aus der englischsprachigen Literatur verwendet. In ihrer einfachsten Ausführungsform enthält diese mittelwertbildende Schaltung ein Schieberegister, das mit dem pulsdichtemodulierten Signal gespeist ist und dessen Ausgangssignale als Strom- oder Spannungssignale über eine Summierschaltung zusammengefaßt werden. Der Summenausgang liefert das gewünschte gemittelte Signal, das in der Regel als Stromsignal einem Kondensator zugeführt ist.

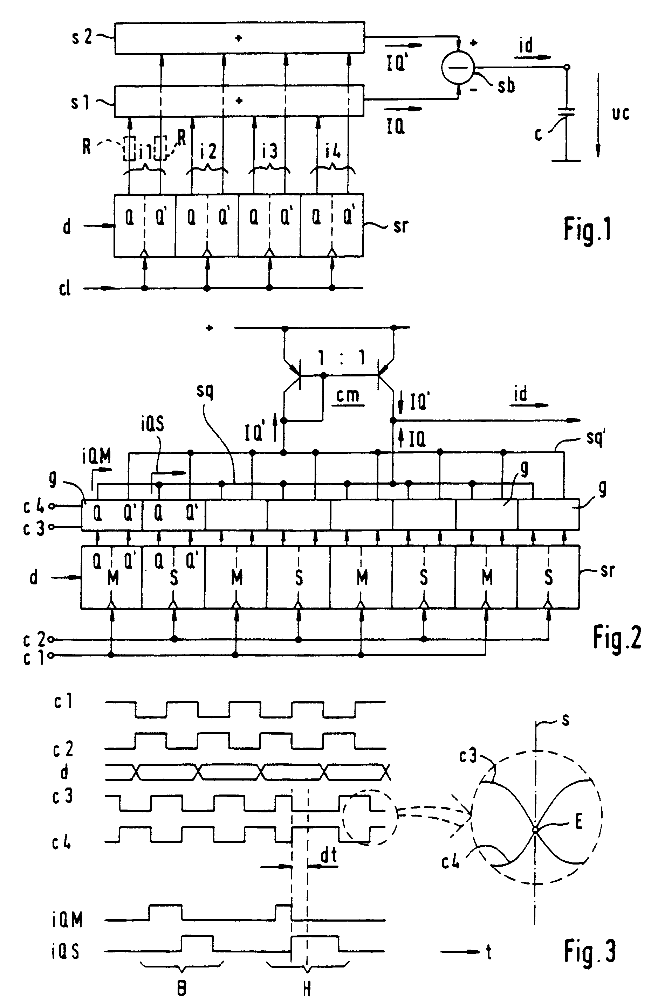

Werden die Signale jeweils gegenphasig an den einzelnen Schieberegisterzellen abgegriffen, dann werden die gleichsinnigen Komponenten summiert und danach die Differenz aus beiden Summen gebildet. Die Differenz stellt das gewünschte gemittelte Signal dar, diesmal aber ohne konstanten Gleichanteil (Fig. 1).

Durch die hohen Taktfrequenzen der pulsdichtemodulierten Signale wirken sich folgende Schaltungs- oder Signaleigenschaften störend auf die Mittelwertbildung aus:

- Abweichungen vom genauen Umschaltzeitpunkt der einzelnen Signale, wobei die Abweichungen durch Schaltungsunsymmetrien, durch Phasenzittern oder durch die Datenvorgeschichte bedingt sein können, und
- Amplitudenschwankungen der einzelnen Signale, beispielsweise infolge von Signalrauschen oder Störsignaleinkopplung.

Die Auswirkungen von Schaltungsunsymmetrien, die sich beispielsweise in unterschiedlichen An- und Abstiegsflanken äußern können, sowie die Auswirkungen der Datenvorgeschichte werden durch Torschaltungen verhindert, die jeder einzelnen Schieberegisterzelle zugeordnet sind. Dabei schneiden die Torschaltungen aus jedem Datenintervall ein kürzeres Torintervall aus, so daß die Mittelwertbildung mit diesem zeitlich verkürzten Signal durchgeführt wird. Jede logische "1" stellt unabhängig von der Datenvorgeschichte einen eigenen Impuls dar, der vom logischen Pegel "0" ausgeht. Unsymmetrien in der An- und Abstiegsflanke können sich somit nicht mehr störend auswirken. Und da jedes Signal bei der logischen "0" beginnt, ist auch die Datenvorgeschichte ohne Belang. Leider erhöht dieses Verfahren, das auch als "gating" bezeichnet wird, die Empfindlichkeit gegenüber dem Phasenzittern, weil die Phasenschwankungen im Verhältnis zum verkürzten Torintervall verstärkt in Erscheinung treten.

Die nachteiligen Auswirkungen des Phasenzitterns auf die Torintervalle lassen sich nach EP - A-0 335 988 (= US -A-4947171) dadurch umgehen, daß die Torbildung sowohl in der Master- als auch in der Slave-Phase des Schiebetaktes erfolgt. Dabei werden die Signale der Q-Ausgänge aller Tore summiert und entsprechend die Signale der Q'-Ausgänge (Fig. 2). Durch die Einbeziehung der Master- und Slave-Phase in die Torbildung, werden die Phasenschwankungen des Tortaktes kompensiert. Ist beispielsweise das Torintervall in der Master-Phase zu lang, dann ist zwangsweise das Torintervall in der Slave-Phase entsprechend verkürzt, vgl. Fig. 3. Die Taktunempfindlichkeit ist wesentliche Voraussetzung für Umsetzer mit hoher Auslösung.

EP - A-0 335 988 beschreibt ferner, wie die Amplituden der einzelnen Signale gleichmäßiger realisiert werden können, indem für jedes Signal eine separate Signalquelle verwendet wird. Der logische Zustand der Master- und Slave-Zellen und das Torsignal steuern dabei lediglich den Signalpfad in der jeweiligen Torschaltung für die separate Signalquelle. Dabei befinden sich hintereinandergeschaltet zwei elektronische Umschalter in jeder Torschaltung. Der erste verbindet außerhalb des Torintervalls die Signalquelle mit einem neutralen Torausgang oder während des Torintervalls mit dem Eingang des zweiten elektronischem Umschalters. Die Steuerung des ersten elektronischen Umschalters erfolgt über einen taktabhängigen Steuereingang, dem das Torsignal zugeführt ist. Die Steuerung des zweiten elektronsichen Umschalters erfolgt über einen datenabhängigen Steuereingang, der mit dem Q- und Q'-Ausgang der zugehörigen Master- oder Slave-Zelle verbunden ist. Die beiden Ausgangsanschlüsse des zweiten elektronischen Umschalters bilden den Q- und Q'-Anschluß der Torschaltung.

Da Ströme leicht zu schalten und zu summieren sind, sind alle Signalquellen mittels separater Konstantstromquellen realisiert, die alle gemeinsam an einer Vorspannungsquelle angeschlossen sind. Alle Q'-Anschlüsse der Torschaltungen sind auf eine gemeinsame erste Stromsammelschiene zusammengeschaltet und dem Eingang einer Stromspiegelschaltung zugeführt, die als Stromdifferenzstufe dient. Ebenso sind alle Q-Anschlüsse der Torschaltungen gemeinsam über eine zweite Stromsammelschiene zusammengefaßt, die mit dem Ausgang der Stromspiegelschaltung verbunden ist und an deren Verbindungsknoten der Differenzstrom abgreifbar ist. Schließlich sind auch alle neutralen Toranschlüsse gemeinsam über eine Tor-Stromsammelschiene zusammengefaßt, die mit einer neutralen Stromsenke verbunden ist.

Der Tortakt ist synchron zum Schiebetakt, weist gegen diesen jedoch eine gewisse Phasenverschiebung zur sicheren Datenübernahme auf. Alternierend werden so entweder alle Master- oder alle Slave-Zellen mit der Stromdifferenzstufe bzw. mit der neutralen Stromsenke verbunden.

2

Die Stromdifferenzbildung erfolgt in der EP - A- 0 335 988 mittels eines pnp-Transistor-Stromspiegels, dessen Eingang mit der Q-Stromsammelschiene und dessen Ausgang mit der Q'-Stromsammelschiene verbunden ist. Dabei ist an der Q'-Stromsammelschiene der Differenzstrom als mittelwertbildendes Signal abgreifbar, vgl. Fig. 2.

Die Umsetzung dieser aus EP-A-0 335 988 bekannten Schaltungsanordnung , die in Bipolartechnik realisiert ist, in CMOS-Technik, insbesondere für hohe Taktfrequenzen, ist nicht ohne weiteres möglich. Und dies gilt, obwohl MOS-Transistoren im Gegensatz zu Bipolartransistoren eigentlich ein ideales Stromübersetzungsverhältnis aufweisen, weil vom übertragenen Strom kein Basisstrom abzuzweigen ist. Der Hauptnachteil der MOS-Transistoren ist indessen ihre quadratische Stromkennlinie

$$I_{DS} = \beta (U_{GS} - U_T)^2$$

und ihre relativ große Gate-Source-Kapazität. Dies wirkt sich äußerst nachteilig bei MOS-Stromspiegelschaltungen aus, wenn Ströme mit hohen Frequenzen zu spiegeln sind. Ein Teil des Eingangsstromes wird dabei zur Umladung der Gate-Source-Kapazität der Stromspiegeltransistoren verwendet. Da die Gate-Source-Spannung proportional zur Wurzel des Drain-Stromes und der Gate-Strom proportional zur Änderung der Gate-Source-Spannung ist, ist der Drain-Strom des Ausgangstransistors des Stromspiegels verzerrt, wobei die Verzerrung mit steigender Frequenz entsprechend zunimmt. Diese Verzerrungen fallen bei pulsdichtemodulierten Signalen mit ihren hohen Taktfrequenzen über Signalmischung in das Nutzsignalband.

Es ist daher Aufgabe der in den Ansprüchen gekennzeichneten Erfindung, eine Schaltungsanordnung für mittelwertbildende Digital-Analogumsetzer in CMOS-Technik anzugeben, welche die beschriebenen Nachteile des MOS-Stromspiegels vermeidet.

Neben der eigentlichen Lösung der Aufgabe ergibt sich als weiterer Vorteil, daß die Schaltungsanordnung unempfindlich gegen das 1/f-Rauschen der einzelnen MOS-Stromquellen und gegen das niederfrequente Rauschen der Stromquellen-Bezugsspannung ist.

Die Erfindung wird nun anhand der Figuren der Zeichnung näher erläutert:

Fig. 1 zeigt schematisch als Blockschaltbild eine bekannte Schaltungsanordnung zur Mittelwertbildung bei pulsdichtemodulierten Signalen,

Fig. 2 zeigt schematisch als Blockschaltbild eine bekannte Verbesserung der Schaltungsanordnung nach Fig. 1,

Fig. 3 zeigt schematisch als Zeitdiagramm einige Signalverläufe der Schaltungsanordnung nach Fig. 2 und

Fig. 4 zeigt als Teilschaltbild ein bevorzugtes Ausführungsbeispiel der Erfindung.

Fig. 1 zeigt ein einfaches bekanntes Ausführungsbeispiel eines mittelwertbildenden Digital-Analogumsetzers mit einem vierstufigen Schieberegister sr, dessen Serieneingang ein Datensignal d zugeführt ist, das aus einem pulsdichtemodulierten Signal im Binärcode besteht. Die Q- bzw. Q'-Ausgänge aller Schieberegisterzellen sind mit einem ersten bzw. zweiten Summierer s1, s2 verbunden. Dabei kann z.B. aus dem Ausgangspotential der jeweiligen Zelle mittels eines gestrichelt dargestellten Widerstandes R der jeweilige, datenabhängige Zellenstrom i1, i2, i3, i4 erzeugt werden. Die Ausgänge der beiden Summierer s1, s2, sind mit einem Subtrahierer sb verbunden, der einen Differenzstrom id bildet. Dieser dient als mittelwertbildendes Ausgangssignal, denn sein Wert ist proportional zum Mittelwert von vier aufeinanderfolgenden Logikzuständen des Datensignals d.

In der Regel wird der Differenzstrom id bei der weiteren Verarbeitung mittels eines Kondensators c integriert, an dem als integrales Ausgangssignal die Kondensatorspannung uc abgreifbar ist. Selbstverständlich können die beiden Summierer s1, s2 und der Subtrahierer sb auch an die Verarbeitung von Spannungssignalen angepaßt werden. Das Schieberegister sr ist von einem Takt c1 gesteuert, dessen Taktrate gleich der Datenrate des Datensignals d ist.

Fig. 2 zeigt ein aus EP - A-0 335 988 bekanntes, verbessertes Auführungsbeispiel, mit einer Aufspaltung des Schieberegisters sr in aufeinander folgende Master- und Slave-Zellen H, S. Die Master- bzw. Slave-Zellen sind dabei von einem ersten bzw. zweiten Schiebetakt c1, c2 gesteuert, wobei beide Schiebetakte zusammen einen Zweiphasentakt bilden, der in der Regel nichtüberlappend ausgebildet ist. Durch die Verwendung der Q- und Q'-Ausgänge der Master- und Slave-Zellen M, S verdoppelt sich die Anzahl der an der Mittelwertbildung beteiligten Signale gegenüber Fig. 1.

Jeder Master- und jeder Slave-Zelle M, S ist eine Torschaltung g zugeordnet, die einen datenabhängigen Steuereingang aufweist, der mit dem Q- und Q'-Ausgang der jeweiligen Schieberegisterzelle verbunden ist. Ferner weist jede Torschaltung g einen taktabhängigen Steuereingang auf, dem als Tortakt ein überlappender Zweiphasentakt aus einem ersten und einem zweiten Tortakt c3, c4, von gleicher Frequenz wie die beiden Schiebetakte c1, c2 zugeführt ist. Die beiden Tortakte sind gegenüber den beiden Schiebetakten phasenverzögert, damit das Torintervall nicht in die Schiebephase fällt.

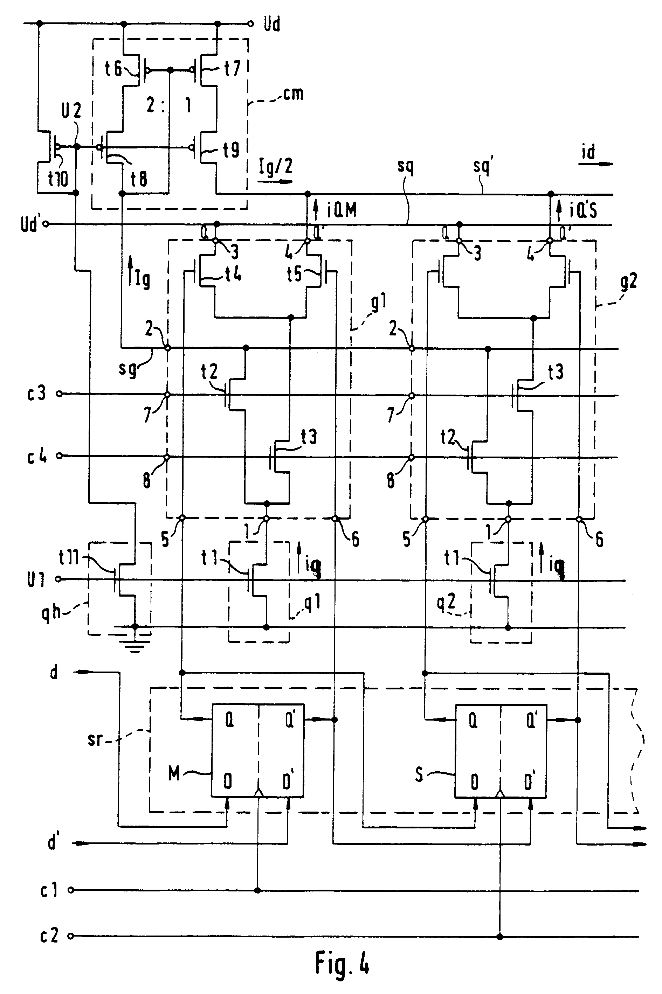

Die Q-Ausgänge Q der Torschaltungen g sind gemeinsam auf eine Q-Stromsammelschiene sq geführt und die Q'-Ausgänge Q' auf eine Q'-Stromsammelschiene sq'. Der besseren Übersichtlichkeit wegen ist in Fig. 2 nicht dargestellt, daß jeder Torschaltung g eine eigene Konstantstromquelle zugeordnet ist, deren Strom aufgrund der jeweiligen Torstellung entweder auf den Q- oder Q'-Torausgang Q, Q' geschaltet ist oder auf einen neutralen Torausgang. Diese neutralen Torausgänge sind gemeinsam über eine Tor-Stromsammelschiene sq (vgl. Fig. 4) auf einen positiven Versorgungsanschluß als neutrale Stromsenke geführt.

Der Q'-Summenstrom IQ' speist den Eingang eines Stromspiegels cm aus zwei gleichen pnp-Transistoren. Der Ausgangsanschluß dieses Stromspiegels cm ist mit der Q-Stromsammelschiene sq verbunden, wodurch am Verbindungsknoten die Differenz aus dem Q'- und dem Q-Summenstrom IQ', IQ gebildet wird. An diesem Verbindungsknoten, der identisch mit der Q-Stromsammelschiene sq ist, kann somit als Ausgangssignal der Differenstrom id abgegriffen werden.

Für die beiden Tortakte c3, c4 ist es wichtig, daß während des gesamten Übernahmevorgangs die Stromaufteilung des jeweiligen Konstantstroms in der Summe stets gleichförmig ist. Damit die von den beiden Tortakten c3, c4 abhängigen Stromintegrale möglichst gleich sind, muß die durch die beiden Übergangsflanken bewirkte Stromaufteilung symmetrisch zum Übergangspunkt E (vgl. Fig. 3) sein und im Übergangspunkt E hälftig. Damit ist die Geometrie der Übergangsflanken, ihr zeitlicher Verlauf und ihre Phasenlage bestimmt.

Für die Mittelwertbildung kann es auch von Interesse sein, wenn die Konstantströme nicht gleich, sondern gewichtet sind. Vorteilhaft ist eine von der Mitte des Schieberegisters sr ausgehende symmetrische Gewichtung, die nach außen abnimmt. Besonders vorteilhaft erweist sich hierbei eine dreiecksförmige Gewichtung. Spiegelbildlich einander zugeordnete Master- und Slave-Zellen M, S dürfen indessen keine Gewichtungsunterschiede aufweisen, z.B. die erste Master- Zelle und die letzte Slave-Zelle des Schieberegisters sr gehören spiegelbildlich zusammen.

Der Ausgleich des Phasenzitterns, den die mit den Master- und Slave-Zellen M, S verbundenen Torschaltungen bewirken, wird anhand einiger typischer Zeitdiagramme in Fig. 3 näher erläutert:

In Fig. 3 zeigen die erste und zweite Zeile den ersten bzw. den dazu invertierten zweiten Schiebtakt c1, c2 deren Taktrate identisch mit der Datenrate des Datensignals d in der dritten Zeile ist. Die aktive (positive) Phase des ersten Schiebetaktes c1, der die Master-Zelle M steuert, erfolgt erst, wenn das Datensignal d einen stabilen Zustand erreicht hat. Durch die aktive (positive) Phase des in der vierten Zeile dargestellten ersten Tortaktes c3 werden alle den Master-Zellen M zugeordneten Torschaltungen g an die Stromdifferenzbildung angeschlossen und durch die aktive (positive) Phase des in der fünften Zeile dargestellten zweiten Tortaktes c4 alle Torschaltungen g, die den Slave-Zellen S zugeordnet sind. Stellvertretend für alle Ausgangsströme wird in der sechsten Zeile von Fig. 3 der Q-Ausgangsstrom iQM dargestellt, der der ersten Master-Zelle M zugeordnet ist, und in der siebten Zeile der Q-Ausgangsstrom iQS, der der ersten Slave-Zelle S zugeordnet ist.

Im Bereich B sind die Tortakte c3, c4 nicht gestört, während im Bereich H der Umschaltzeitpunkt des ersten und zweiten Tortaktes c3, c4 um das Zeitintervall dt verfälscht ist. Entsprechend ist der Q-Ausgangsstrom iQM im Master-Bereich um das Zeitintervall dt verkürzt und der Q-Ausgangsstrom iQS im Slave-Bereich um das gleiche Zeitintervall dt verlängert. Durch die Summierung der beiden Q-Ausgangsströme ändert sich jedoch die gesamte Stromflußzeit nicht, so daß der Phasenfehler für die nachfolgende Mittelwertbildung nicht in Erscheinung tritt.

Der Übergangsbereich der in Fig. 3 schematisch als Rechtecksignale dargestellten ersten und zweiten Torsignale c3, c4 ist in einem nebenstehenden Ausschnitt genauer dargestellt. Dabei schneiden sich die beiden Übergangsflanken in einem Übergangspunkt E, der auch die Symmetrielinie s für die Stromaufteilung festlegt. Die Überlappung und damit die Lage des Übergangspunktes E muß sicherstellen, daß nur eine Verteilung des Konstantstromes und keine Abschwächung oder gar Unterdrückung stattfindet.

Das in Fig. 4 als bevorzugtes Ausführungsbeispiel der Erfindung dargestellte Teilschaltbild enthält einen Großteil der aus Fig. 1 oder Fig. 2 bekannten Grundelemente, die mit den entsprechenden gleichen Bezugszeichen versehen sind. Eine nochmalige ausführliche Beschreibung erübrigt sich somit bei ihnen. Von der gesamten Schieberegisteranordnung sr ist in Fig. 4 lediglich die erste Master- und erste Slave-Zelle M, S mit zugehöriger erster bzw. zweiter Torschaltung g1, g2 dargestellt. Das Datensignal d ist dabei als gegenphasiges Signal d, d' dem D- bzw. D'-Eingang eines als Master-Zelle M dienenden ersten D-Flipflops zugeführt. Daran ist auf übliche Weise ein als Slave-Zelle S dienendes zweites D-Flipflop angeschlossen und so weiter. Die Takteingänge der Master- bzw. Slave-Zellen sind mit dem ersten bzw. zweiten Schiebetakt c1, c2 verbunden, die zusammen einen Zweiphasentakt bilden.

Der Master-Zelle M ist eine erste Konstantstromquelle q1 zugeordnet, die mittels eines n-Kanal-Transistors t1 und eines Stromquellen-Bezugspotentials U1 einen Konstantstrom iq erzeugt. Dieser Konstantstrom iq ist einem Anschluß 1 der ersten Torschaltung g1 zugeführt und wird mittels der beiden als Torschalter dienenden n-Kanal-Transistoren t2, t3 entweder auf einen ersten Torausgang, - Anschluß 2-, oder einen zweiten oder dritten Torausgang, - Anschluß 3 oder 4 -, geschaltet. Der Anschluß 3 bzw. 4 ist dabei der Q- bzw. Q'-Ausgang Q, Q' der ersten Torschaltung g1. Der Anschluß 2 wird auch als neutraler Torausgang bezeichnet, weil die Öffnung dieses Torausgangs nur vom Tortakt und nicht vom Datensignal d abhängig ist.

An den Anschlüssen 3 und 4 liegen die Drain-Anschlüsse eines als zweiter Torschalter dienenden n-Kanal-Tranistorpaares t4, t5 , deren gemeinsamer Source-Anschluß mit dem Drain-Anschluß des Transistors t3 verbunden ist. Der Gate-Anschluß des Transistors t4 bzw. t5 bildet den Anschluß 5 bzw. 6 der ersten Torschaltung g1, der mit dem Q- bzw. Q'-Ausgang der Master-Zelle M verbunden ist. Die Anschlüsse 5 und 6 bilden somit den datenabhängigen Steuereingang der ersten Torschaltung g1.

Der Gate-Anschluß des Transistors t2 bzw. t3 bildet den Anschluß 7 bzw. 8 der ersten Torschaltung g1 und ist mit dem ersten bzw. zweiten Torsignal c3, c4, gespeist. Damit bilden die Anschlüsse 7 und 8 gemeinsam den taktabhängigen Steuereingang der ersten Torschaltung g1. Die n-Kanal-Transistoren t2 bis t5 schalten somit den zugeführten Konstantstrom iq auf einen der drei Torausgänge, Anschluß 2 oder 3 oder 4, um.

Die der Slave-Zelle S zugeordnete zweite Torschaltung g2 ist in ihrer internen und äußeren Beschaltung bis auf die Ansteuerung der n-Kanal-Transistoren t2 und t3 identisch mit der ersten Torschaltung g1. In der zweiten Torschaltung g2 ist nämlich der Gate-Anschluß des n-Kanal-Transistors t2 bzw. t3 mit dem Anschluß 8 bzw. 7 der zweiten Torschaltung g2 verbunden und damit mit dem zweiten bzw. ersten Tortakt c4, c3 gespeist. Die miteinander verbundenen Anschlüsse 2 aller Torschaltungen bilden eine Tor-Stromsammelschiene sg, die mit dem Eingang eines Stromspiegels cm aus p-Kanal-Transistoren t6 bis t9 verbunden ist. Ferner bilden die zusammengeschalteten Anschlüsse 4 aller Torschaltungen eine Q'-Stromsammelschiene sq', die mit dem Ausgangsanschluß des Stromspiegels cm zur Stromdifferenzbildung verbunden ist. Dabei weist der Stromspiegel cm von seinem Eingang zum Ausgang eine Stromuntersetzung vorzugsweise vom Faktor 0,5 auf. Schließlich sind die Anschlüsse 3 aller Torschaltungen zu einer Q-Stromsammelschiene sq zusammengeschaltet und mit einem beliebigen positiven Versorgungspotential Ud' als Stromsenke verbunden. Der Summenstrom auf dieser Stromsammelschiene sq wird zur Bildung des Differenzstromes id nicht verwendet.

Der wesentliche Vorteil dieser Anordnung liegt nun darin, daß der Stromspiegel cm an seinem Eingang einen konstanten Summenstrom Ig sieht, der genau so groß wie der halbe Summenstrom aller Konstantstromquellen q1, q2, ... ist. Der gespiegelte Strom Ig/2 ist somit ebenfalls ein konstanter Strom. Von diesem Stromspiegel-Ausgangsstrom Ig/2 werden nun je nach der Taktphase die datenabhängigen Q'-Ausgangsströme iQ'M bzw. iQ'S der Master- bzw. Slave-Abschnitte abgezogen. Als resultierendes Signal kann dann auf der Q'-Stromsammelschiene sq' der Differenzstrom id abgegriffen werden.

Der Faktor der Stromuntersetzung ist durch denjenigen Datenbezugspegel bestimmt, bei dem der Differenzstrom id zu Null werden soll. Das Verhältnis, das aus dem Wertebereich des Datensignals d unterhalb dieses Datenbezugspegels und dem Gesamtwertebereich gebildet ist, gibt den Stromuntersetzungsfaktor an. Ein üblicherweise symmetrischer Wertebereich ergibt den Stromuntersetzungsfaktor 0,5.

Durch die Belastung des Stromspiegelausganges mit einem Offsetgleichstrom kann ebenfalls eine Unsymmetrie der Wertebereiche erzwungen werden, die dann beim Stromuntersetzungsfaktor zu berücksichtigen ist. Im Grenzfall weist der Stromspiegel cm überhaupt keine Stromuntersetzung auf, wenn z.B. der Offsetgleichstrom gleich dem halben Summenstrom Ig/2 ist und der Datenbezugspegel in der Mitte des Gesamtwertebereiches liegt.

Von besonderem Vorteil erweist sich bei der Schaltungsanordnung nach Fig.4, daß das störende 1/f-Rauschen der n-Kanal-Stromquellen q1, q2, ... nur reduziert in Erscheinung tritt, weil für das Rauschen des Summenstroms Ig die gesamte Gate-Fläche aller n-Kanal-Konstantstromquellen-Transistoren t1 maßgebend ist. Niederfrequente Rauschanteile überlagern sich zwar dem Summenstrom Ig, gleichverkoppelt aber auch den Q'-Ausgangsströmen iQ'M bzw. iQ'S der Torschaltungen g1, g2 und kompensieren sich daher teilweise. Die Wirkung der Kompensation ist aussteuerungsabhängig. Der resultierende 1/f-Rauschanteil ist dabei direkt proportional zur Größe des Differenzstroms id. Für Audiosignale ist dies von großem Vorteil, weil das Rauschverhalten dann weniger wahrnehmbar ist. In gleicher Weise wird niederfrequentes Rauschen des Stromquellen-Bezugspotentials U1 durch die gemeinsame Auswirkung auf den Konstantstromquellen-Summenstrom und den gespiegelten Strom kompensiert. Der Eigenbeitrag des p-Kanal-Stromspiegels cm zum Rauschverhalten ist im Vergleich zum Beitrag der Konstantstromquellen q1, q2, ... gering. Die beschriebene Rauschkompensation des 1/f-Rauschens setzt voraus, daß die Datenrate sehr hoch gegenüber dem Frequenzbereich des 1/f-Rauschens ist.

Der aus den p-Kanal-Transistoren t6 bis t9 gebildete Stromspiegel cm enthält im Eingang und Ausgang jeweils einen p-Kanal-Kaskodetransistor t8 bzw. t9. Deren Gate-Anschlüsse liegen gemeinsam an einem Gate-Bezugspotential U2. Dieses ist durch einen als Diode geschalteten p-Kanal-Transistor t10 gebildet, desssen gemeinsamer Gate-Source-Anschluß von einer Hilfs-Konstantstromquelle qh mit einem Konstantstrom gespeist ist. Diese Hilfs-Konstantstromquelle qh besteht aus einem n-Kanal-Transistor t11, dessen Gate-Anschluß mit dem Stromquellen-Bezugspotential U1 verbunden ist. Der Fußpunkt des Stromspiegels cm, der durch die Source-Anschlüsse der Transistoren t6 und t7 gebildet ist und der Source-Anschluß des Transistors t10 liegen gemeinsam am positiven Versorgungspotential Ud.

Der Aussteuerbereich des Differenzstroms id ist +/-(Ig/2), also doppelt so groß wie der Ausgangsstrom Ig/2 des Stromspiegels cm. Wenn der Stromspiegel cm mit einem weiteren Ausgang versehen wird, der ebenfalls den Strom Ig/2 liefert, dann kann dieser Anschluß mit der Q-Stromsammelschiene sq zur Bildung eines invertierten Differenzstroms verwendet werden.

**Patentansprüche**

1. CMOS-Schaltung für mittelwertbildende Digital-Analogumsetzer mit
   - einem von einem Schiebetakt (c1, c2) gesteuerten Schieberegister (sr) aus alternierend in Reihe geschalteten Master- und Slave-Zellen (M, S), dessen Serieneingang mit einem pulsdichtemodulierten Signal, einem Datensignal (d), gespeist ist,
   - jeder Master- und jede Slave-Zelle (M, S) ist eine Torschaltung (g1, g2) und eine Konstantstromquelle (q1, q2) zugeordnet, die aufgrund der jeweiligen Torstellung auf einen von drei Torausgängen (Q, Q′, 2) geschaltet ist,
   - ein datenabhängiger Steuereingang der jeweiligen Torschaltung (g1, g2) ist mit dem Q′- und Q′-Ausgang (Q, Q′) der Master- oder Slave-Zelle (M, S) verbunden,
   - ein taktabhängiger Steuereingang der jeweiligen Torschaltung (g1, g2) ist mit einem Tortakt (c3, c4) gespeist,
   - alle Q- bzw. Q′- bzw. neutralen Ausgänge (Q, Q′, 2) der Torschaltungen (g1, g2) sind zu einer Q- bzw. Q′- bzw. Tor-Stromsammelschiene (sq, sq′, sg) zusammengefaßt, und
   - ein Stromspiegel (cm) ist mit zwei dieser drei (Q-, Q′-, Tor-)Stromsammelschienen (sq, sq′, sg) zur Bildung eines als Ausgangssignal dienenden Differenzstromes (id) verbunden,

   gekennzeichnet durch folgende Merkmale:
   - der Eingang des Stromspiegels (cm) ist mit der Tor-Stromsammelschiene (sg) und der Ausgang mit der Q- oder Q′-Stromsammelschiene (sq, sq′) verbunden und
   - der Stromspiegel (cm) weist vom Eingang zum Ausgang eine definierte Stromuntersetzung auf, deren Untersetzungsfaktor so bestimmt ist, daß beim Datenbezugspegel des Datensignals (d) der Wert des Differenzstromes (id) null ist.

2. CMOS-Schaltung nach Anspruch 1, dadurch gekennzeichnet, daß der Stromspiegel (cm) p-Kanal-Transistoren (t6, t7, t8, t9) und die Konstantstromquellen (q1, q2) jeweils mindestens einen n-Kanal-Transistor (t1) enthalten.

3. CMOS-Schaltung nach Anspruch 2, dadurch gekennzeichnet, daß der Stromspiegel (cm) im Ein- und Ausgang jeweils einen p-Kanal-Kaskodetransistor (t8, t9) enthält.

4. CMOS-Schaltung nach Anspruch 2, dadurch gekennzeichnet, daß die Gate-Anschlüsse aller strombestimmenden n-Kanal-Transistoren (t1) der Konstantstromquellen (q1, q2) mit einem Stromquellen-Bezugspotential (U1) verbunden sind.

5. CMOS-Schaltung nach Anspruch 1, dadurch gekennzeichnet, daß die Konstantstromquellen (q1, q2) gewichtet sind, wobei die Gewichtung von der Mitte des Schieberegisters (sr) nach außen spiegelbildlich abnimmt, und daß spiegelbildlich zusammengehörige Master- und Slave-Zellen (M, S) keine Gewichtungsunterschiede aufweisen.

6. CMOS-Schaltung nach Anspruch 5, dadurch gekennzeichnet, daß die Gewichtung der Konstantstromquellen (q1, q2) einen dreiecksförmigen Verlauf aufweist.

7. CMOS-Schaltung nach Anspruch 3, dadurch gekennzeichnet, daß die Gate-Anschlüsse der p-Kanal-Kaskodetransistoren (t8, t9) mit einem Gate-Bezugspotential (U2) verbunden sind, das mittels einer Hilfs-Konstantstromquelle (qh) und einem als Diode geschalteten p-Kanal-Transistor (t10) gebildet ist, dessen Source-Anschluß auf dem gleichen Potential wie Fußpunkt des Stromspiegels (cm) liegt.

8. CMOS-Schaltung nach Anspruch 1, gekennzeichnet durch folgende Merkmale:
   - der Schiebetakt ist ein Zweiphasentakt aus einem ersten und einem zweiten Schiebetakt (c1, c2),
   - der Tortakt ist ein überlappender Zweiphasentakt aus einem ersten und einem zweiten Tortakt (c3, c4) und
   - die Übergangsflanken des ersten und zweiten Tortaktes (c3, c4) sind in ihrem zeitlichen Verlauf und in ihrer Phasenlage zueinander so aufeinander abgestimmt, daß
     -- die Stromaufteilung in der jeweiligen Torschaltung (g1, g2) in der Summe stets gleichförmig ist,
     -- die durch die beiden Übergangsflanken bewirkte Stromaufteilung symmetrisch zum Übergangspunkt (E) ist und
     -- im Übergangspunkt (E) der Strom der Konstantstromquelle (q1, q2) hälftig aufgeteilt ist.

9. CMOS-Schaltung nach einem der Ansprüche 1, 2 oder 3, dadurch gekennzeichnet, daß der Stromspiegel (cm) eine Stromuntersetzung mit dem Faktor 0,5 aufweist.

**Claims**

1. CMOS circuit for averaging digital-to-analog converters
   - which includes a shift register (sr) consisting of alternately series-connected master and slave cells (M, S) and controlled by a shift clock (c1, c2), the serial input of said shift register (sr) being supplied with a pulse-density-modulated signal, a data signal (d),
   - wherein each master cell (M) and each slave cell (S) has a gate circuit (g1, g2) and a constant-current source (q1, q2) associated therewith, said constant-current source (q1, q2) being connected to one of three gate outputs (Q, Q′, 2) depending on the respective position of the gate,
   - wherein a data-dependent control input of the respective gate circuit (g1, g2) is connected to the Q and Q′ outputs (Q, Q′) of the master or slave cell (M, S),
   - wherein a clock-dependent control input of the respective gate circuit (g1, g2) is supplied with a gate clock (c3, c4),
   - wherein all Q, Q′ and neutral outputs (Q, Q′, 2) of the gate circuits (g1, g2) are combined into a Q bus (sq), a Q′ bus (sq′), and a gate bus (sg), respectively, and
   - wherein a current mirror (cm) is connected to two of said three (Q, Q′, and gate) buses (sq, sq′, sg) to form a differential current (id) serving as an output signal,
   characterized by the following features:
   - The input of the current mirror (cm) is connected to the gate bus (sg), and the output to the Q or Q′ bus (sq, sq′), and
   - the current mirror (cm) has a defined current scaling factor such that the value of the differential current (id) is zero at the data reference level of the data signal (d).

2. A CMOS circuit as claimed in claim 1, characterized in that the current mirror (cm) contains p-channel transistors (t6, t7, t8, t9), and that each of the constant-current sources (q1, q2) contains at least one n-channel transistor (t1).

3. A CMOS circuit as claimed in claim 1, characterized in that the current mirror (cm) includes a p-channel cascode transistor (t8) at the input and a p-channel cascode transistor (t9) at the output.

4. A CMOS circuit as claimed in claim 2, characterized in that the gate terminals of all current-determining n-channel transistors (t1) of the constant-current sources (q1, q2) are connected to a current-source reference potential (U1).

5. A CMOS circuit as claimed in claim 1, characterized in that the constant-current sources (q1, q2) are weighted, with the weighting decreasing from the middle of the shift register (sr) toward the outside in a mirror-symmetrical manner, and that master and slave cells (M, S) belonging together from the point of view of mirror symmetry exhibit no differences in weighting.

6. A CMOS circuit as claimed in claim 5, characterized in that the weighting of the constant-current sources (q1, q2) has a triangular characteristic.

7. A CMOS circuit as claimed in claim 3, characterized in that the gate terminals of the p-channel cascode transistors (t8, t9) are connected to a gate reference potential (U2) established by means of an auxiliary constant-current source (qh) and a diode-connected p-channel transistor (t10) whose source terminal is at the same potential as the bottom end of the current mirror (cm).

8. A CMOS circuit as claimed in claim 1, characterized by the following features:
   - The shift clock is a two-phase clock consisting of a first and a second shift clock (c1, c2);
   - the gate clock is an overlapping two-phase clock consisting of a first and a second gate clock (c3, c4), and
   - the transition edges of the first and second gate clocks (c3, c4) are so adjusted in their variation with time and their phase position that
     -- the current division in the respective gate circuit (g1, g2) is always invariant in its sum,
     -- the current division caused by the two transition edges is symmetrical about the transition point (E), and
     -- the current from the constant-current source (q1, q2) is divided into two equal parts at the transition point (E).

9. A CMOS circuit as claimed in claim 1, 2 or 3, characterized in that the current mirror (cm) has a current scaling factor of 0.5.

## Revendications

1. Circuit CMOS pour convertisseur numérique/ analogique formant une valeur moyenne, comprenant
   - un registre à décalage (sr), commandé par une cadence de décalage (c1,c2) et constitué par des cellules maîtres et esclaves (M,S), branchées en série d'une manière alternée et dont l'entrée série est alimentée par un signal modulé selon une modulation de densité d'impulsions, un signal de données (d),
   - à chaque cellule maître et à chaque cellule esclave (M,S) sont associés un circuit de porte (g1,g2) et une source de courant constant (q1,q2), qui sont raccordés, sur la base de la position respective de la porte, à l'une de trois sorties (Q,Q',2) de la porte,
   - une entrée de commande, qui dépend des données, du circuit de porte respectif (G1,G2) est reliée à la sortie Q et à la sortie Q' (Q,Q') de la cellule maître et de la cellule esclave (M,S),
   - une entrée de commande qui dépend de la cadence du circuit de porte respectif (g1,g2) est alimentée par une cadence de porte (C3,C4),
   - toutes les sorties Q ou Q' ou neutre (Q,Q',2) des circuits de porte (g1,g2) sont réunies pour former un rail omnibus de courant de Q ou Q' ou de porte (sq, sq', sg), et
   - un miroir de courant (cm) est relié à deux de ces trois rails omnibus de courant (de Q, de Q', de porte) (sq, sq', sg) pour former un courant différentiel (id) utilisé comme signal de sortie,
   caractérisé par les caractéristiques suivantes :
   - l'entrée du miroir de courant (cm) est reliée au rail omnibus de courant de porte (sg), et la sortie est reliée au rail omnibus de courant de Q ou Q' (sq, sq'), et
   - le miroir de courant (cm) présente, de l'entrée à la sortie, une réduction définie de courant, dont le facteur de réduction est déterminé de telle sorte que, pour le niveau de référence de données du signal de données (d), la valeur du courant différentiel (d) est nulle.

2. Circuit CMOS suivant la revendication 1, caractérisé en ce que le miroir de courant (cm) contient des transistors à canal p (t6,t7,t8,t9) et les sources de courant constant (q1,q2) contiennent respectivement au moins un transistor à canal n (t1).

3. Circuit CMOS suivant la revendication 2, caractérisé en ce que le miroir de courant (cm) contient, à l'entrée et à la sortie, respectivement un transistor cascode à canal p (t8,t9).

4. Circuit CMOS suivant la revendication 2, caractérisé en ce que les bornes de grille de tous les transistors à canal n (tl), qui déterminent le courant, des sources de courant constant (q1,q2) sont reliées à un potentiel de référence (U1) des sources de courant.

5. Circuit CMOS suivant la revendication 1, caractérisé en ce que les sources de courant constant (q1, q2) sont pondérées, la pondération diminuant symétriquement à partir du centre du registre à décalage (sr) en direction de l'extérieur, et que des cellules maîtres et esclaves (M, S), qui sont associées symétriquement, ne présentent aucune différence de pondération.

6. Circuit CMOS suivant la revendication 5, caractérisé en ce que la pondération des sources de courant constant (q1,q2) possède une allure de forme triangulaire.

7. Circuit CMOS suivant la revendication 3, caractérisé en ce que les bornes de grille des transistors cascode à canal p (t8,t9) sont reliées à un potentiel de référence de grille (U2), qui est formé, au moyen d'une source de courant constant auxiliaire (qh) et d'un transistor à canal p (t10) branché en diode et dont la borne de source est placée au même potentiel que le point de base du miroir de courant (cm).

8. Circuit CMOS suivant la revendication 1, caractérisé par les caractéristiques suivantes :
   - la cadence de décalage est une cadence biphasée formée par une première cadence de décalage et une seconde cadence de décalage (c1,c2),
   - la cadence de porte est une cadence biphasée en chevauchement formée par une première cadence de porte et une seconde cadence de porte (c3,c4), et
   - les flancs de jonction des première et seconde cadences de porte (c3,c4) sont accordés entre eux en ce qui concerne leur variation dans le temps et leur position de phase réciproque de telle sorte que
     -- la répartition du courant dans le circuit de porte respectif (g1,g2) dans la somme est toujours uniforme,
     -- la répartition du courant, qui est provoquée par les deux flancs de jonction, est symétrique par rapport au point de jonction (E), et
     -- au niveau du point de jonction (E), le courant de source de courant constant (q1,q2) est réparti par moitié.

9. Circuit CMOS suivant l'une des revendications 1, 2 ou 3, caractérisé en ce que le miroir de courant (cm) présente une réduction de courant correspondant au facteur 0,5.

Fig.1

Fig.2

Fig.3

10

Fig. 4